# EUROPEAN PATENT APPLICATION

(11) **EP 2 098 969 A1**
(43) Date of publication of application: **09.09.2009**
(21) Application number: 07860062.4
(22) Date of filing: 25.12.2007
(51) Int. Cl.: G06F 17/50

(54) **LOGIC CIRCUIT DESIGNING DEVICE FOR ASYNCHRONOUS LOGIC CIRCUIT, LOGIC CIRCUIT DESIGNING METHOD, AND LOGIC CIRCUIT DESIGNING PROGRAM**

(30) Priority: 26.12.2006 JP 2006349365
(71) Applicant: NEC Corporation, Minato-ku Tokyo 108-8001 (JP)
(72) Inventor: TANAKA, Katsunori, Tokyo 108-8001 (JP)
(74) Representative: Vossius & Partner
(86) International application number: PCT/JP2007/074833
(87) International publication number: WO 2008/078740

(57) **Abstract**

A logic circuit designing device for designing an asynchronous logic circuit which satisfies characteristic constraints of a state holding element represented by a latch or a flip-flop is provided. A signal transition series which generates a control signal pulse of the state holding element is extracted by the state storage control signal transition series extraction unit 112 from a state transition graph applied to the logic circuit designing device and a minimum delay constraint of a signal line path corresponding to the signal transition series is set as a minimum pulse width constraint value of the state holding element by the pulse generation path delay constraint setting addition unit 115 to execute logic synthesis.

## Description

### TECHNICAL FIELD

The present invention relates to designing of a logic circuit and, more particularly, a logic circuit designing device, a logic circuit designing method and a logic circuit designing program for an asynchronous logic circuit.

### Background ART

As disclosed in non-patent Literature 1 and non-patent Literature 2, a designing device of an asynchronous logic circuit of this kind has a function, in order to make a logic element as a component of a circuit to be designed function normally and make the entire circuit operate according to specifications, of automatically setting design constraints related to timing while adding a part of performance and constraints of the component of the relevant circuit to constraints designated by a designer.

Logic circuits are classified into a combinational circuit and a sequential circuit, with the combinational circuit being a logic circuit whose output signal is uniquely determined for an input signal independently of a previous state and the sequential circuit being a logic circuit which has a combinational circuit and a state holding unit and whose output signal is determined for a current state and an input signal. A logic circuit having a practical function such as a central processor is designed as a sequential circuit.

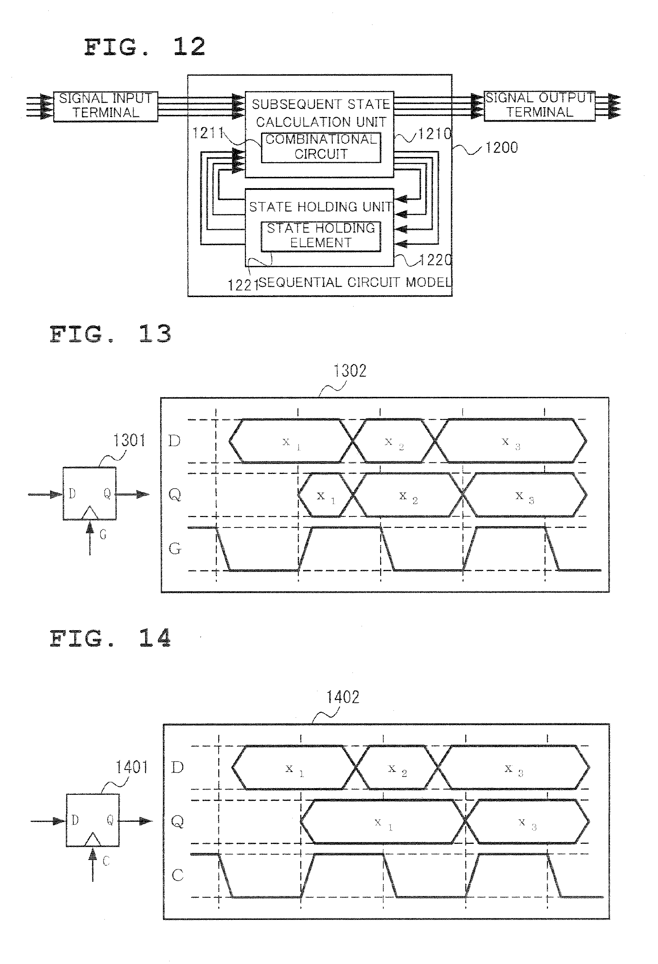

The sequential circuit has an input terminal 1230 for an external signal, an output terminal 1240 for an external signal, a state holding unit 1220 and a subsequent state calculation unit 1210 as components as shown in Fig. 12, with the state holding unit 1220 realized by a state holding element 1221 whose representative is a latch or a flip-flop and the subsequent state calculation unit 1210 realized by a combinational circuit 1211 by AND, OR and NOT cells.

In a sequential circuit 1200, the subsequent state calculation unit 1210 and the state holding unit 1220 are in the lump called a data path and on the data path, the combinational circuit 1211 of the subsequent state calculation unit 1210 executes operation of calculating external signal input data as signal data externally input through the signal input terminal 1230 and data held in the state holding unit 1220 to output a result of the calculation to the signal output terminal 1240 or the state holding unit 1220, and the state holding unit 1220 executes operation of storing the result of the calculation.

As described above, as the state holding element 1221 for realizing the sequential circuit 1200, a latch and a flip-flop are used.

The latch is a logic element having a data input (D input) terminal and a gate input (G input) terminal as an input terminal and a data output (Q output) terminal as an output terminal as indicated by a logic element symbol 1301 in Fig. 13.

The latch, as shown in a timing chart 1302 in Fig. 13, executes, when a value of the G input is 1, operation of passing a value of the D input to the Q output, when the value of the G input changes from 1 to 0, operation of storing the passing value of the D input and considering the value as a value of the Q output, when the value of the G input is 0, operation of holding the value of the Q output and when the value of the G input changes from 0 to 1, operation of taking the held value of the Q output as the value of the D input.

The flip-flop, as indicated by a logic element symbol 1401 in Fig. 14, is a logic element having a data input (D input) terminal and a clock input (C input) terminal as an input signal terminal and a data output (Q output) terminal as an output terminal.

The flip-flop, as shown by a timing chart 1402 in Fig. 14, executes, when a value of the C input changes from 0 to 1, operation of storing a value of the D input and considering the value as a value of the Q output and when the value of the C input fails to change or changes from 1 to 0, operation of holding the value of the Q output.

As described above, because the G input of the latch and the C input of the flip-flop control storage of the relevant state holding element, the inputs will be referred to as a storage control input or simply as a control input.

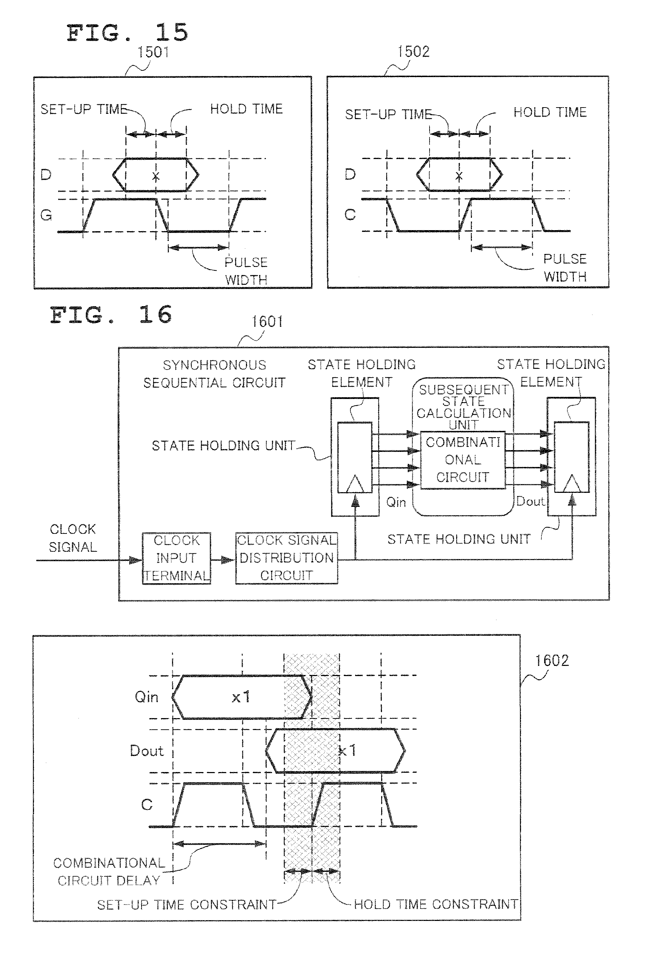

Required for operating the state holding element normally are a time for stabilizing the value of the D input before the value of the control input changes for storing the value of the D input which time is represented as a set-up time in a timing chart 1501 and a timing chart 1502 in Fig. 15, a time for stabilizing the value of the D input before an internal signal of the state holding element stabilizes after the value of the control input changes for storing the value of D input which time is represented as a hold time in the figure and a time for stabilizing the value of the control input until the internal signal of the state holding element stabilizes after the value of the control input changes which time is represented as a pulse width in the figure. Minimum time constraints on a set-up time, a hold time and a pulse width of the state holding element will be referred to as set-up time constraints, hold time constraints and minimum pulse width constraints, respectively. These constraints are those based on characteristics of the state holding element.

Sequential circuits are classified into a synchronous sequential circuit and an asynchronous sequential circuit according to a signal to a control input of a state holding element in the sequential circuit.

The synchronous sequential circuit is a sequential circuit which has such a structure as shown in a circuit example (a synchronous sequential circuit 1601) in Fig. 16 to apply a clock signal oscillating between 0 and 1 at a fixed cycle as indicated by C (input) of a timing chart 1602 to control inputs of all the state holding elements in the state holding unit to synchronize operation of all the state holding elements with the clock signal.

Executed in designing of the synchronous sequential circuit is designing of a clock signal distribution circuit for distributing a clock signal and a data paths.

The clock signal distribution circuit is designed to make a delay from a clock input terminal which receives input of a clock signal to a terminal of a control input of all the state holding elements be as even as possible.

In designing of a data path of the synchronous sequential circuit, a state holding unit is designed to be formed of necessary state holding elements and a combinational circuit in a subsequent state calculation unit between state holding elements is designed to realizes a logic function which is applied as a design specification. In the designing, the combinational circuit is given constraints that calculation should be completed within one clock cycle time arbitrarily set by a designer.

In ordinary designing of a synchronous sequential circuit, as recited in the non-patent Literature 1, for example, for considering all the constraints based on characteristics of a state holding element in designing of a combinational circuit in a subsequent state calculation unit between state holding elements, constraints are set such that a combinational circuit delay of the combinational circuit is not less than a hold time of a state holding element on an output side and not more than a time obtained by subtracting a set-up time of the state holding element on the output side from a clock cycle time, and a clock signal cycle time and a duty ratio are appropriately set as shown in the timing chart 1602 in Fig. 16.

On the other hand, an asynchronous sequential circuit is a sequential circuit in which no clock signal is input to a control input of a state holding element in the asynchronous sequential circuit and state holding elements adjacent to each other through a combinational circuit of a subsequent state calculation unit on a data path execute cooperative operation buy communication of a handshake signal of a request signal requesting storage and a notification signal indicative of the completion of the relevant storage operation.

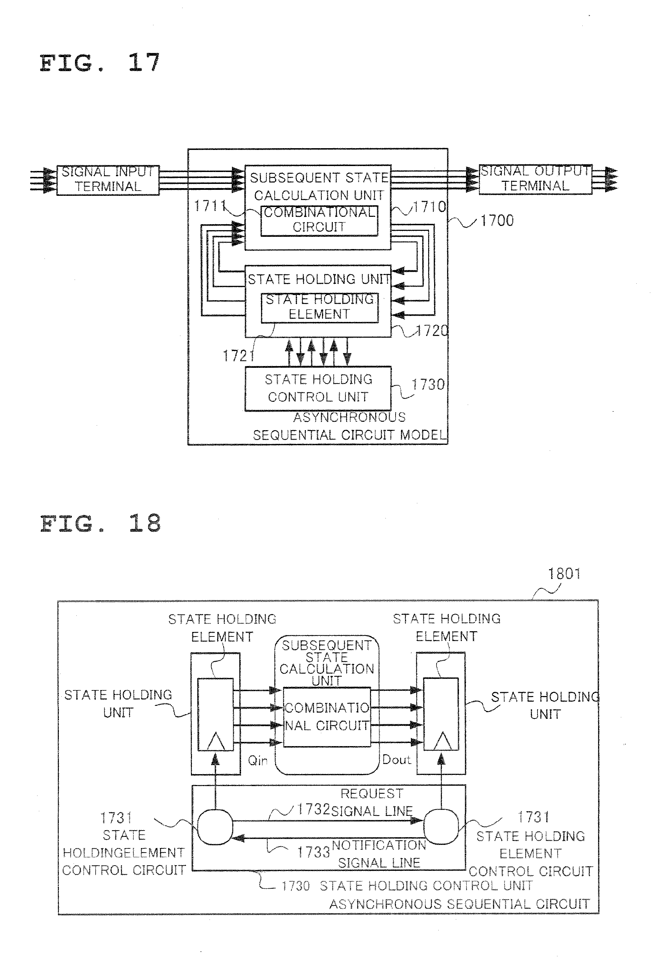

For executing cooperative operation of a state holding element by communication of the handshake signal, the asynchronous sequential circuit takes a basic structure as shown in a block diagram of Fig. 17 and has a subsequent state calculation unit 1710, a state holding unit 1720 and a state storage control unit 1730 which outputs a signal to a terminal of a control input of a state holding element 1721 as components.

The state storage control unit 1730 in the asynchronous sequential circuit comprises a state holding element control circuit 1731 as a circuit for controlling each state holding element, a request signal line 1732 and a notification signal line 1733 as a handshake signal line between the state holding element control circuits as shown by a structure example of an asynchronous sequential circuit 1801 in Fig. 18.

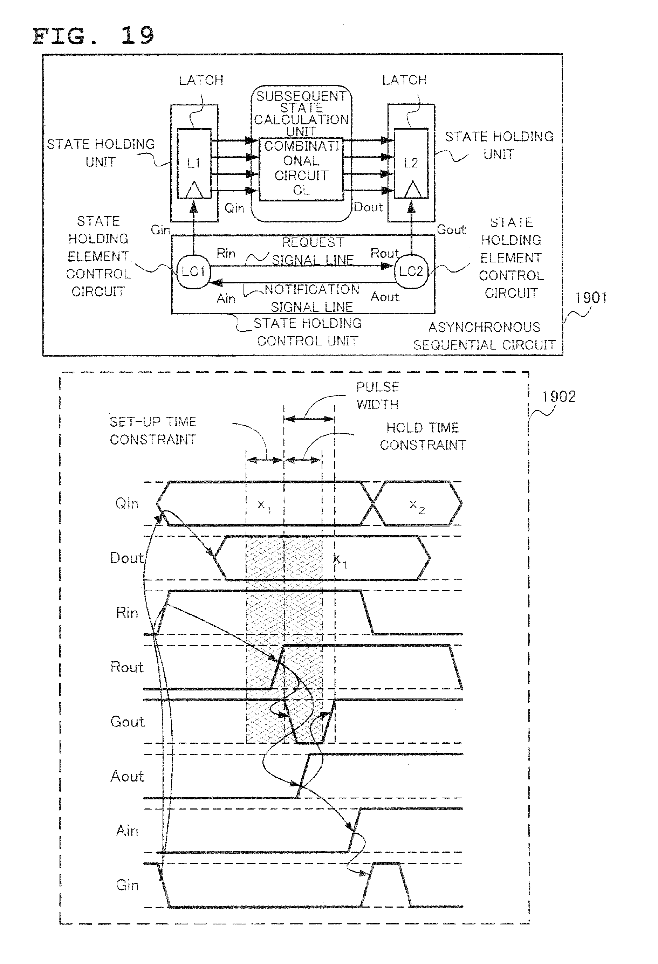

Cooperative operation between state holding elements adjacent to each other through the combinational circuit in the subsequent calculation unit on a data path of the asynchronous sequential circuit is realized as illustrated by a timing chart 1902 for a circuit example (an asynchronous sequential circuit 1901) in Fig. 19, by, at the time of storage operation of the state holding element on the input side of the combinational circuit, the State holding element control circuit for controlling the state holding element to send (Rout) a request signal (Rin) for requesting storage to the state holding element control circuit for controlling the state holding element on the output side of the combinational circuit and the state holding element control circuit for controlling the state holding element on the output side to send a state storage control signal (Gout) to the state holding element on the output side such that the state holding element on the output side executes storage operation upon arrival of the request signal (Rout) and to send (Ain) a notification signal (Aout) indicative of completion of the storage operation to the state holding element control circuit on the input side.

Designing of an asynchronous sequential circuit is made based on designing of a data path and designing of the state storage control unit.

In designing of the data path of the asynchronous sequential circuit, the state holding unit is designed to comprise a state holding element and the subsequent state calculation unit is designed as a combinational circuit which realizes a logic function defined by design specifications.

Designing of the state storage control unit is made by defining a signal transition series to be realized as a state transition graph which is a graph expression having a directed branch of a sequence relationship between signal transitions as a nodal point of signal transition, generating a state graph having a directed branch of a signal transition with a signal state as a nodal point from the state transition graph and extracting a logic function to be realized by an intermediate signal and an cutout signal as an expression intermediate signal and an output signa as an expression by a signal in the circuit from the state graph to synthesize a logic circuit which realizes the logic function.

For realizing a sequence in which a state holding element on an output side of the combinational circuit in a data path stores a result of calculation after completion of the calculation of the combinational circuit as recited in non-patent Literature 2, ordinarily, an asynchronous logic designing technique has constraints imposed that a request signal line delay is larger than a delay of the combinational circuit in the subsequent state calculation unit along the request signal line in designing of the state storage control unit. Common asynchronous logic designing technique accordingly has a sufficient margin of a constraint value in the request signal line delay constraints in order to satisfy set-up time constraints and hold time constraints of the state holding element.

With the asynchronous logic circuit design using the above-described method, among constraints based on characteristics of a state holding element, a minimum pulse width constraint might not be satisfied.

The reason is that while delays of a logic gate and a wiring are reduced as circuit techniques advance to enable designing of a circuit for high-speed generation of an output timing control signal which controls storage operation of the state holding element and a pulse width as rise and fall time intervals of the control signal becomes smaller than a minimum pulse width constraint value as a lower limit value guaranteeing normal operation of the state holding element to increase a possibility that a designing resultant circuit will violate the constraint, the asynchronous logic circuit designing method recited in the literature fails to explicitly consider the above-described constraints because it has a little possibility of violation of the above-described constraints.

On the other hand, Patent Literature 1 discloses a pulse width checking method in which a pulse detection device checks pulse width constraints by using event occurrence time detection information in a simulation device.
Patent Literature 1: Patent No. 2633648
Non-Patent Literature 1: Jan M. Rabaey, Ananda Chandrakasan, Borivoje Nikolic, Digital Integrated Circuits, 2nd Edition, Person Education Inc., pp. 491-533.
Non-Parent literature 2: Jeans Sparse, Steve Furber, Principles of Asynchronous Circuit Design, Kluwer Academic Publishers, 2001, pp. 16-27, pp. 81-114.

Problem in the asynchronous logic circuit designing by the method recited in the above-described Patent literature 1 is that a minimum pulse width constraint among constraints based on characteristics of a state holding element might not be satisfied.

The reason is that since in a simulation-based pulse width checking method, a state as of prior to pulse occurrence is unclear, a theoretically right minimum pulse width constraint can not be always calculated.

### (THE OBJECT OF THE INVENTION)

An object of the present invention is to provide a logic circuit designing device, a logic circuit designing method and a logic circuit designing program enabling designing of an asynchronous logic circuit which takes a theoretically right minimum pulse width constraint of a state holding element into consideration and satisfies the constraint.

### SUMMARY

An asynchronous logic circuit designing device of the present invention includes a design constraint setting unit which sets constraints, as constraint information on designing of a signal line path which generates a control signal for controlling storage operation of a state holding element, that a minimum delay time of the signal line path is a minimum time interval between a rise transition and a fall transition of the control signal required for normal operation of the state holding element.

The present invention enables designing of a logic element taking all the theoretically right timing constraints into consideration.

### BRIEF DESCRIPTION OF THE DRAWINGS

Fig. 1 is a block diagram showing a structure of a first mode of implementation of the present invention;
Fig. 2 is a block diagram showing a hardware structure example of an asynchronous logic circuit designing device 100 of an asynchronous logic circuit designing system according to the first mode of implementation;
Fig. 3 is a flow chart showing operation of the first mode of implementation;
Fig. 4 shows an example of data path design information of a first exemplary embodiment of the present invention;
Fig. 5 shows an example of entire structure design information of an asynchronous logic circuit to be designed according to the first exemplary embodiment;
Fig. 6 shows an example of a state transition graph of a state storage controls unit according to the first exemplary embodiment;
Fig. 7 shows an example of input/output signal information of the state storage control unit according to the first exemplary embodiment;
Fig. 8 shows an example of design constraint input information of the first exemplary embodiment;
Fig. 9 shows an example of a cell library of the first exemplary embodiment;
Fig. 10 shows an example of pulse generation signal line path minimum delay constraint addition of the first exemplary embodiment;
Fig. 11 shows a design example of a partial circuit in the state storage control unit as a result of application of the present invention according to the first exemplary embodiment;
Fig. 12 shows a common model of a sequential circuit;
Fig. 13 shows an element symbol of a latch and a timing chart of the latch;
Fig. 14 shows an element symbol of a flip-flop and a timing chart of the flip-flop;
Fig. 15 is a timing chart showing a set-up time and a hold time of the latch and the flip-flop;
Fig. 16 shows a block diagram illustrating a structure of a synchronous sequential circuit and a timing chart indicative of a relationship among a set-up time constraint, a hold time constraint and a combinational circuit delay of a subsequent state calculation unit in the synchronous sequential circuit;
Fig. 17 shows a common model of an asynchronous sequential circuit;
Fig. 18 is a circuit structure diagram for use in explaining a connection relationship among a state holding element, a state storage control circuit and a handshake signal in the asynchronous sequential circuit; and
Fig. 19 shows an example of a partial circuit of the asynchronous sequential circuit, operation of the circuit example and a timing chart indicative of a relationship among each signal in the circuit example, a set-up time constraint, a hold time constraint and a pulse width.

### EXEMPLARY EMBODIMENT

### (FIRST MODE OF IMPLEMENTATION)

Next, a first mode of implementation of the present invention will be described in detail with reference to the drawings.

### (STRUCTURE OF FIRST MODE OF IMPLEMENTATION)

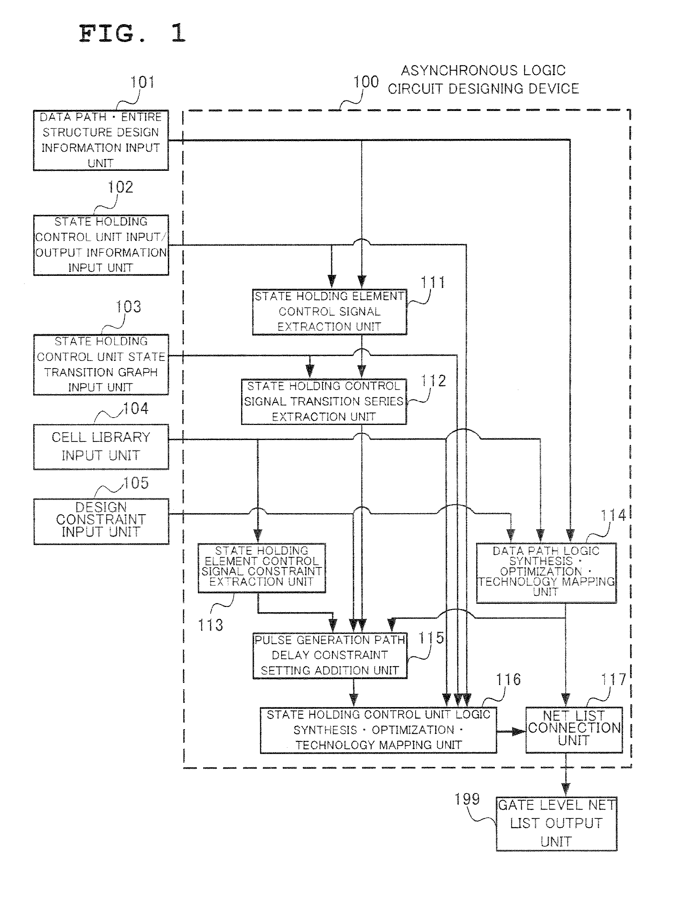

Fig. 1 is a block diagram showing a structure of an asynchronous logic circuit designing system according to the present mode of implementation.

With reference to Fig. 1, the asynchronous logic circuit designing system according to the present mode of implementation comprises an asynchronous logic circuit designing device 100, a data path entire structure design information input unit 101, a state storage control unit input/output information input unit 102, a state storage control unit state transition graph input it 103 a cell library input unit 104 a design constraint input unit 105 and a gate level net list output unit 199.

The asynchronous logic circuit design device 100 includes a State holding element control signal extraction unit 111, a state storage control signal transition series extraction unit 112, a stare holding element control signal constraint extraction unit 113, a data path logic synthesis·optimization· technology mapping unit 114, a pulse generation path delay constraint setting addition unit 115, a state storage control unit logic synthesis·optimization·technology mapping unit 116 and a net list connection unit 117.

These units and parts have the following functions, respectively.

The data path·entire structure design information input unit 101 has a function of applying information related to design specifications of a data path formed of a subsequent state calculation unit and a state holding unit in an asynchronous logic circuit to be designed and information related to entire structure design indicative of a connection relationship of each unit of the asynchronous logic circuit to the asynchronous logic circuit designing device 100.

The state storage control unit input/output information input unit 102 has a function of applying information related to an input/output signal name of a state storage control unit in the asynchronous logic circuit to be designed to the asynchronous logic circuit designing device 100.

The state storage control unit state transition graph input unit 103 has a function of applying information (state transition graph) indicative of an operation specification of the state storage control unit and a sequence relationship of an internal signal transition in a relevant internal circuit out of the asynchronous logic circuit to be designed to the asynchronous logic circuit designing device 100.

The cell library input unit 104 has a function of applying a cell library as information related to a cell used as a component of the asynchronous logic circuit to be designed, cell performance and timing constraints to the asynchronous logic circuit designing device 100.

The design constraint input unit 105 has a function of applying constraint information on designing (design constraint) arbitrarily set based on required specification performance of the asynchronous logic circuit to be designed to the asynchronous logic circuit designing device 100.

The gate level net list output unit 199 has a function of outputting a net list of a gate level of the asynchronous logic circuit to be designed from the asynchronous logic circuit design device 100.

The state holding element control signal extraction unit 111 has a function of extracting a signal name of a state storage control signal for controlling storage of a state holding element from information related to a data path design specification input to a relevant unit from the data path·entire structure design information input unit 101 and information related to entire structure design (data path·entire structure design information) and applying the signal name to the state storage control signal transition series extraction unit 112.

The state storage control signal transition series extraction unit 112 has a function of specifying, from a state transition graph and a signal name applied to the unit from the state storage control unit state transition graph input unit 103 and the state holding element control signal extraction unit 111, nodal points at signal rise and fall transitions of the relevant signal name in the relevant state transition graph to extract a signal transition series as a series of nodal points connected by a branch between relevant nodal points.

The state holding element control signal constraint extraction unit 113 has a function of extracting a state holding element and a minimum pulse width constraint of a control signal of the element from a cell library applied to the unit from the cell library input unit 104.

The data path logic synthesis·logic optimization·technology mapping unit 114 has a function of interpreting data path·entire structure design information applied to the unit from the data path· entire structure design information input unit 101, generating information related to a data path circuit of a gate level with a cell defined in a cell library applied to the unit from the cell library input unit 104 as a component so as to satisfy design constraints input to the unit from the design constraint input unit 105 and outputting information related to entire structure together with information related to the data path circuit of the gate level to the pulse generation path delay constraint setting addition unit 115 and the net list connection unit 117.

The pulse generation path delay constraint setting addition unit 115 has a function of extracting and correlating kind information indicating whether a state holding element with a signal as a starting point and an end point of a signal transition series input to the unit from the state storage control signal transition series extraction unit 112 as a control signal is a latch or a flip-flop from information related to a gate level of a data path logic circuit applied to the unit from the data path logic synthesis·logic optimization·technology mapping unit 114 and setting a minimum delay of a signal line path of the signal transition series two be a minimum pulse width constraint value of the state holding element applied to the unit to add the setting of the minimum delay of the signal line path (delay information) to information related to design constraints applied to the unit from the design constraint input unit 105.

The state storage control unit logic synthesis· optimization·technology mapping unit 116 has a function of executing logic synthesis, logic optimization, technology mapping by executing delay addition and the like so as to satisfy design constraints input to the unit from the design constraint input unit 105, with a logic circuit which realizes a relevant logic function by generating a state graph from a state transition graph applied to the unit from the state storage control unit state transition graph input unit 103 to extract a logic function between signal lines as a logic circuit formed of a cell defined in a cell library input to the unit from the cell library input unit 104.

The net list connection unit 117 has a function of connecting a net list of a partial circuit of the asynchronous logic circuit to be designed which is individually subjected to logic synthesis · logic optimization · technology mapping and applied to the unit from the data path logic synthesis · logic optimization · technology mapping unit 114 and the state storage control unit logic synthesis · optimization · technology mapping unit 116 according to information related to the entire structure applied to the unit to generate a net list of the entire asynchronous logic circuit to be designed.

Here, a hardware structure of the asynchronous logic circuit designing device 100 will be described.

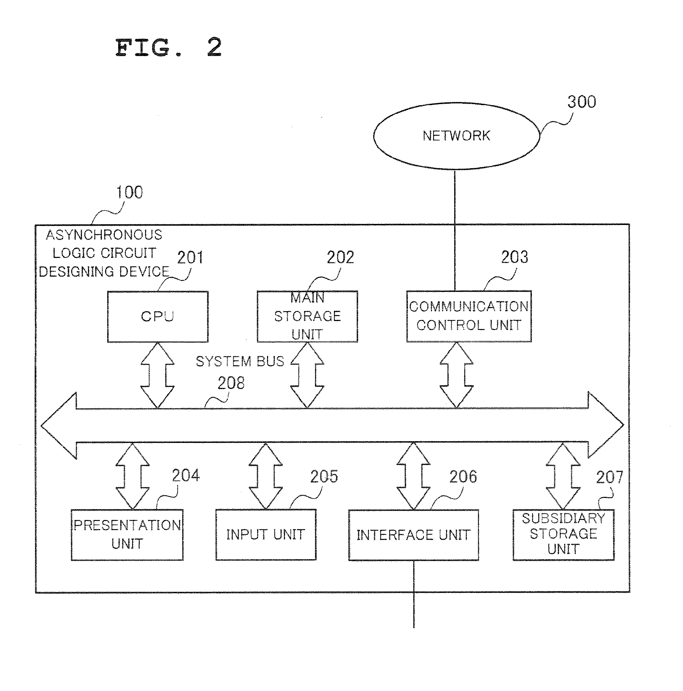

Fig. 2 is a block diagram showing a hardware structure example of the asynchronous logic circuit, designing device 100 of the asynchronous logic circuit designing system according to the present mode of implementation.

With reference to Fig. 2, the asynchronous logic circuit designing device 100 according to the present invention, which can be realized by the same hardware structure as that of a common computer device, comprises a CPU (Central Processing Unit) 201, a main storage unit 202 which is a main memory such as a RAM (Random Access Memory) for use as a data working area or a data temporary save area, a communication control unit 203 for transmitting and receiving data through an internet 300, a presentation unit 204 such as a liquid crystal display, a printer or a speaker, an input unit 205 such as a keyboard or a mouse, an interface unit 206 connected to a peripheral apparatus for transmitting and receiving data, a subsidiary storage unit 207 as a hard disk device formed of a non-volatile memory such as ROM (Read Only Memory), a magnetic disk or a conductor memory, and a system bus 208 for connecting the above-describde components of the present information processing device with each other.

The asynchronous logic circuit designing device 100 according to the present invention has its operation realized not only by hardware with a circuit part formed of a hardware part such as LSI (Large Scale Integration) in which a program realizing such functions is incorporated mounted within the asynchronous logic circuit designing device 100 but also by software by executing a program providing each function of the above-described components by the CPU 201 on the computer processing device.

More specifically, the CPU 201 realizes the above-described respective functions as software by loading a program stored in the subsidiary storage unit 207 into the main storage unit 202 and executing the same, thereby controlling operation of the asynchronous logic circuit designing device 100.

Other components of the asynchronous logic circuit designing system may have such a structure as described above and the function of each of the above-described components may be realized as hardware software.

### (OPERATION OF FIRST MODE OF IMPLEMENTATION)

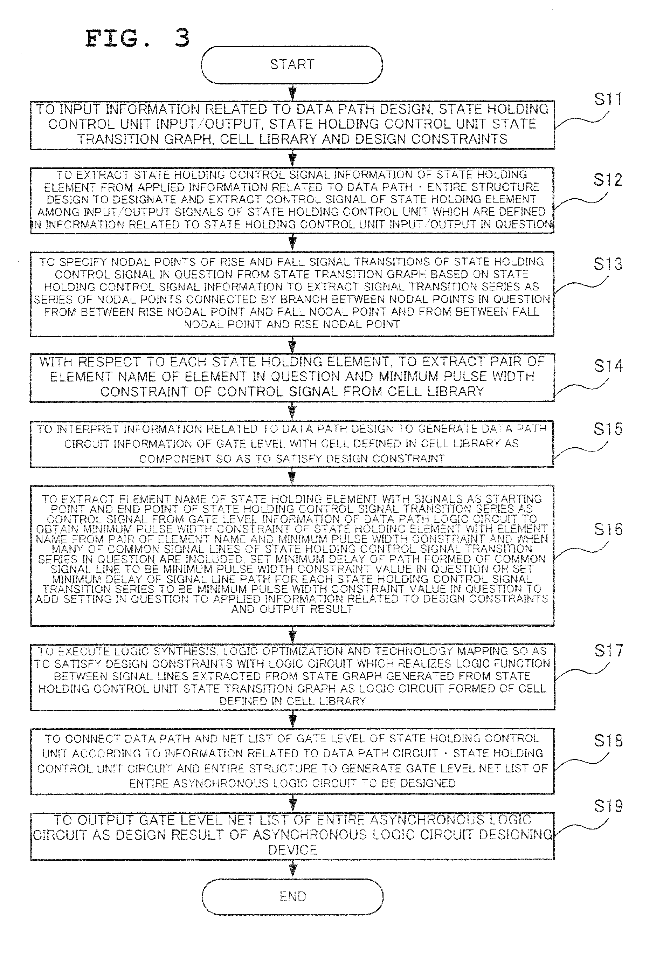

Next, with reference to Fig. 1 and Fig. 3, detail description will be made of operation of the entire asynchronous logic circuit designing system according to the present mode of implementation.

Fig. 3 is a flow chart showing operation of the present mode of implementation.

Information related to data path design, entire structure design, a state storage control unit input/output, a state storage control unit state transition graph, a cell library and design constraints is applied to the asynchronous logic circuit designing device 100 through the data path · entire structure design information input unit 101, the state storage control unit input/output information input unit 102, the state storage control unit state transition graph input unit 103, the cell library input unit 104 and the design constraint input unit 105 (Step S11).

The information related to the data path · entire structure design and the state storage control unit input/output is applied to the state holding element control signal extraction unit 111, and the state holding element control signal extraction unit 111 extracts control signal information such as a control signal name of a state holding element (state storage control signal information) from the information related to the data path · entire structure design, designates a control signal of the state holding element among input/output signals of the state storage control unit defined in the information related to the state strage control unit lnput/output and extracts the same (Step S12).

The state storage control unit state transition graph and the state storage control signal information extracted at the storage control signal extraction unit 111 are applied to the state storage control signal transition series extraction unit 112, and the state storage control signal transition series extraction unit 112 specifies nodal int of rise and fall signal transitions of the state storage control signal from the state transition graph based on the state storage control signal information to extract a signal transition series as a series of nodal points connected by a branch between the nodal points from between the rise nodal point and the fall nodal point and from between the fall nodal point and the rise nodal point (Step S13).

The cell library is applied to the state holding element control signal constraint extraction unit 113, and the state holding element control signal constraint extraction unit 113 extracts from the cell library, as to each state holding element, a pair of an element name of the element and a minimum pulse width constraint of a control signal (Step S14) .

The information related to the data path design, the cell library and the constraint information on design (design constraint) are applied to the data path logic synthesis · optimization · technology mapping unit 114, and the data path logic synthesis · optimization · technology mapping unit 114 interprets the information related to the data path design to generate data path circuit information of a gate level with a cell defined in the cell library as a component so as to satisfy the design constraint (:tep S15).

The state storage control signal transition series extracted at the state storage control signal transition series extraction unit 112, the pair of the element name of the state holding element and the minimum pulse width constraint extracted at the state holding element control signal constraint extraction unit 113, the data path circuit information of a gate level generated at the data path logic synthesis · optimization · technology mapping unit 114 and the design constraint input through the design constraint input unit 105 are applied to the pulse generation path delay constraint setting addition unit 115, and the pulse generation path delay constraint setting addition unit 115 extracts an element name of a state holding element with signals as a starting point and an end point of the state storage control signal transition sequence as a control signal from gate level information of the relevant data path logic circuit, obtains a minimum pulse width constraint of the state holding element having the element name from the pair of an element name and a minimum pules width constraint and when many of common signal lines of the state storage control signal transition series are included, sets a minimum delay of a path formed of the common signal line to be the minimum pulse width constraint value or sets a minimum delay of a signal line path for each state storage control 1 signal transition series to be the minimum pulse width constraint value, and adds the setting to the information related to the design constraints which is input to the relevant unit ro output information related to design constraints ass result of the addition (Step S16).

The state storage control unit input/output information, the state storage control unit state transition graph, the cell library and the information related to design constraints output at the pulse generation path delay constraint setting addition unit 115 are input to the state storage control unit logic synthesis · optimization · technology mapping unit 116, and the state storage control unit logic synthesis · optimization · technology mapping unit l16 executes logic synthesis, logic optimization and technology mapping so as to satisfy the design constraints with a logic circuit which realizes a logic function between signal lines extracted from a state graph generated from the state storage control unit state transition graph as a logic circuit formed of a cell defined in the cell library (Step S17).

The data path circuit information of a gate level and the information related to the entire structure generated at the data path logic synthesis · optimization · technology mapping unit 114, and the state storage control unit circuit information of a gate level generated at the state storage control unit logic synthesis · optimization · technology mapping unit 116 are applied to the net list connection unit 117, and the net list connection unit 117 connects the data path and a net list of a gate level of the state storage control unit according to the information related to the entire structure to generate a gate level net list of the entire asynchronous logic circuit to be designed (Step S18).

The gate level net list of the entire asynchronous logic circuit to be designed which is generated by the net list connection unit 117 is output as a design result of the asynchronous logic circuit designing device 100 by the gate level net list output unit 199 (Step S19).

### (EFFECTS OF FIRST MODE OF IMPLEMENTATION)

Next, effects of the present mode of implementation will be described.

According to the present invention, a logic element can be designed taking all the theoretically right timing constraints into consideration.

The reason is that because the system us structured to extract a signal line path in the state storage control unit which generates a pulse of a control signal for controlling storage operation of the state holding element to set a minimum delay of the signal line path which determines a pulse width of the control signal to be a minimum pulse width constraint value of the state holding element a time between a rise transition and a fall transition of the control signal can be maintained not less than the minimum pulse width constraint value to enable an asynchronous logic circuit to be designed which satisfies the minimum pulse width constraint.

More specifically, the reason is that a logic element whose timing constraint is defined is only a state holding element represented by a latch or a flip-flop and a normal operation condition of the state holding element is to satisfy all of the set-up time constraint, the hold time constraint and the minimum pulse width constraint and that the minimum pulse width constraint not considered by the conventional methods among these constraints is to extract, with respect to each of two signal transitions on a signal line on which the constraint is imposed, a series of transitions on other signal line which will cause the transition in question from a state transition graph and set a minimum delay of a signal line path corresponding to the series to be a minimum pulse width to apply logic synthesis · optimization · technology mapping having a delay adjustment unit represented by buffer insertion, thereby obtaining an asynchronous sequential circuit in which a time interval between two transitions on the signal line on which the constraint is imposed becomes not less than a constraint value.

### (FIRST EXEMPLARY EMBODIMENT)

Next, operation of he present invention will be describes with respect to a specific exemplary embodiment. The present exemplary embodiment corresponds to the above-described first mode of implementation.

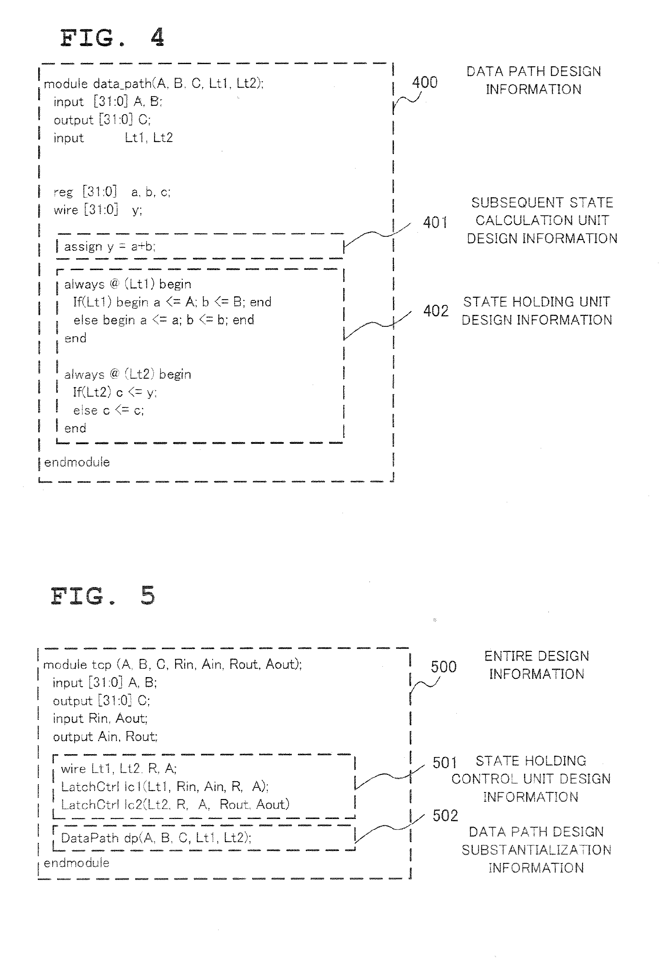

As a design example, design information 400 of a data path shown in Fig. 4 and design information 500 of the entire asynchronous logic circuit (entire design information) shown in Fig. 5 are input to the asynchronous logic circuit designing device 100 in Fig. 1 by the data path design information input unit 101 in Fig. 1.

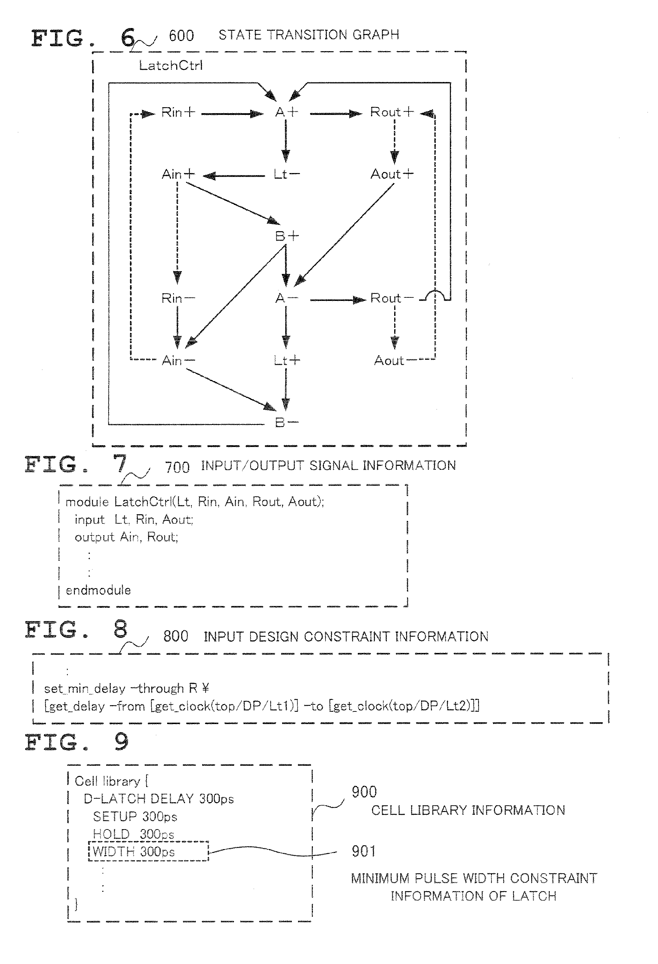

A state transition graph 600 of the state storage control unit shown in Fig. 6 is input to the asynchronous logic circuit designing device 100 in Fig. 1 by the state storage control unit state transition graph input unit 103 in Fig. 1.

Information related to an input/output terminal (input/output signal information 700) of the state storage control unit in Fig. 7 is input to the asynchronous logic circuit designing device 100 in Fig. 1 by the state storage control unit input/output information input unit 102 in Fig. 1.

Information related to design constraint (input design constraint information 800) in Fig. 8 is input to the asynchronous logic circuit designing device 100 in Fig. 1 by the design constraint input unit 105 in Fig. 1.

Assume that a cell defined in cell library information 900 of Fig which is applied to the asynchronous logic circuit designing device 100 in Fig. 1 by the cell library input unit 104 in Fig. 1 is used as a part of a design resultant circuit.

Here, the design information 400 of a data path in Fig. 4 includes design information 401 of the subsequent state calculation unit and design information 402 of the state holding unit.

In addition, the design information 500 of the entire asynchronous logic circuit (entire design information) in Fig. 5 includes design information 501 of the state storage control unit (state storage control unit design information) and design information 502 of a data path as a part which executes circuit substance generation of the data path design information 400 (data path design substantialization information) in Fig. 4.

The state holding element control signal extraction unit 111 in Fig. 1 obtains, from the design information 402 of the state holding unit (state holding unit design information) in Fig. 4, information (state holding element control signal information) that in the state storage control unit Lt1 and Lt2 are control signal oaf the state holding element (state holding element control signal) and obtains, from the data path design substantialization information 502 in Fig. 5 and the state holding element control signal information, information that the input/output signals Lt1 and. Lt2 in partial circuits LC1 and LC2 in the state storage control unit are control signal oaf the state holding element and that a first input/output signal in design information of the partial circuit is a state holding element control signal to extracts, from the obtained information, information that an output Lt in the signal information 700 of a state storage control circuit LatchCtrl in Fig. 7 is a state storage control signal.

From the state transition graph 600 of the state storage control unit in Fig. 6 and the information that the output Lt of LatchCtrl extracted by the state holding element control signal extraction unit 111 in Fig. 1 is a state storage control signal, the state storage control transition series extraction unit 112 in Fig. 1 extracts, as a state storage control transition series, signal transition series Lt-→Ain+→B+-→A-→Lt and Lr+→B-→A+→Lt- between Lt+ and Lt- on the state transition graph.

The state holding element control signal constraint extraction unit 113 in Fig. 1 extracts a pair of an element name of a state holding element and a minimum pulse width constraint of the element from the cell library information 900 in Fig. 9 and extracts, as one of relevant pairs, a pair whose element name and a minimum pulse width constraint are a D latch and 300ps which pair is defined in the information related to design constraints (minimum pulse width constraint information 901 of the latch) on Fig. 9, for example.

The data path logic synthesis · optimization · technology mapping unit 114 in Fig. 1 executes logic synthesis · optimization · technology mapping with respect to the data path design information 400 in Fig. 4 by using the cell library information 900 in Fig. 9 and related tools to define a kind of state holding element (latch/flip-flop) controlled by the state storage control signal Lt. In the present exemplary embodiment, it is assumed that the design information 402 of the state holding unit (state holding unit design information) in Fig. 4 is mapped to the D latch of the cell library information 900 in Fig. 9.

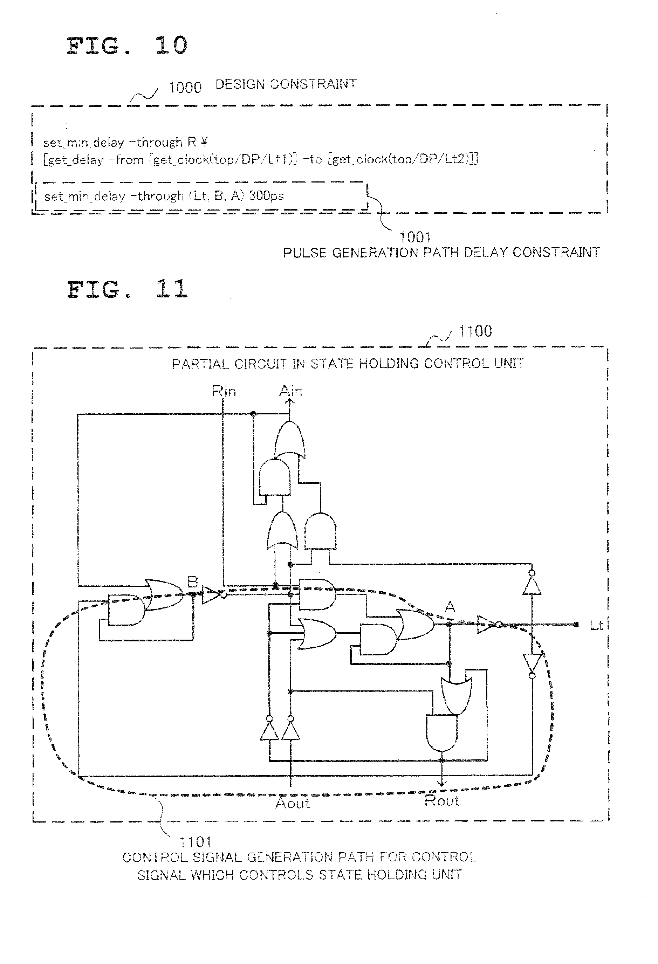

Since for the state storage control signal to satisfy the minimum pulse width constraint of the state holding element, transition times of the state storage control transition series Lt-→Ain+→B+→A-→Lt+ and Lt+→B-→A+→Lt- need to be not less than 300ps which is the minimum pulse width constraint value of the D latch, the pulse generation path delay constraint setting unit 115 in Fig. 1 sets delay information with a minimum delay of a path passing through the signal lines Lt, B and A which the two signal transition series commonly include as 300ps, adds the relevant constraint setting (the set delay information) as a pulse generation path delay constraint 1001 to the input design constraint information 800 in Fig. 8 which is applied to the unit, and obtains information related to design constraint (design constraint 1000) illustrated in Fig. 10.

The state storage control unit logic synthesis · optimization · technology mapping unit 116 in Fig. 1 has a function of outputting such a partial circuit 1100 in the state storage control unit as illustrated in Fig. 11 with the set delay information, the state transition graph and the cell library as input to reflect the set delay information, with which function, a delay value of a path in the partial circuit (a control signal generation path 1101 for a control signal which controls the state holding unit) will be not less than 300 ps.

The net list of a gate level of a logic circuit of the state storage control unit obtained by the state storage control unit logic synthesis · optimization · technology mapping unit 114 and the net list of a gate level of a data path circuit obtained by the data path logic synthesis · optimization · technology mapping unit 114 are connected according to the entire design information 500 in Fig. 5 the net list connection unit 117 in Fig. 1 to output an asynchronous sequential circuit which satisfies a minimum pulse width constraint targeted by the present invention as a connection result by the gate level net list output unit 199 in Fig. 1.

Although the present invention has been described in the foregoing with respect to the preferred exemplary embodiment, the present invention is not necessarily limited to the above-described exemplary embodiment and can be implemented in variations within a range of its technical idea.

Adopting such a structure as described above, the exemplary embodiment of the present invention enables designing of a logic element taking all the theoretically right timing constraints into consideration by executing logic synthesis · logic optimization · technology mapping under such a constraint as making a time between a rise transition and a fall transition of a control signal of the state holding element be not less than a minimum pulse width constraint value. The reason is that in a logic circuit designing device for designing an asynchronous logic circuit, as constraint information on design for a signal line path which generates a control signal for controlling storage operation of the state holding element, a constraint is set that a minimum delay time of the signal line path is a minimum time interval between a rise transitions and a fall transition of the control signal which is required for normal operation of the state holding element.

While the invention has been particularly shown and described with reference to exemplary embodiments thereof, the invention is not limited to these embodiments. It will be understood by those of ordinary skill in the art that various changes in form and details may be made therein without departing from the spirit and scope of the present invention as defined by the claims.

### INCORPORATION BY REFERENCE

This application claims on priority based on Japanese Patent Application No. 2006-349365 filed on December 26, 2006 and includes all the disclosure thereof.

### INDUSTRIAL APPLICABILITY

The present invention is applicable to designing device, system and program for a digital integrated circuit. Also applicable are to design constraint verifying device, system and program of a digital integrated circuit and design constraint violation part rectifying device, system and program of a digital integrated circuit.

## Claims

1. A logic circuit designing device for designing an asynchronous logic circuit, comprising a design constraint setting unit which sets constraints that as constraint information on design of a signal line path for generating a controls signal which controls storage operation of a state holding element, a minimum delay time of the signal line path is set to be a minimum time interval between a rise transition and a fall transition of said control signal which is required for normal operation of said state holding element.

2. The logic circuit designing device according to claim 1, further comprising a signal line path extraction unit which extracts, based on design specification information of a control signal generation circuit for generating said control signal, a signal line path in the control signal generation circuit which makes said control signal transit.

3. The logic circuit designing device according to claim 1, further comprising a transition series corresponding signal line path extraction unit which extracts, based on design specification information of a control signal generation circuit for generating said control signal, a transition series of input/output of the control signal generation circuit for making said control signal transit and an internal signal to extract a signal line path in the control signal generation circuit corresponding to the transition series.

4. The logic circuit designing device according to claim 3, further comprising:
a control signal extraction unit which extracts said control signal from design information related to a data path circuit,
a first logic synthesis unit which executes logic synthesis · optimization · technology mapping based on the design information related to said data path circuit,
a minimum time interval extraction unit which extracts a kind of said state holding element based on said data path circuit to extract a value of said minimum time interval of the state holding element of said kind based on a cell library,
a second logic synthesis unit which executes logic synthesis · optimization · technology mapping while executing delay addition which satisfies said constraint information on design set to the design specification information of the control signal generation circuit for generating said control signal, and
a logic circuit generation unit which generates an asynchronous logic circuit by connecting said data path circuit and said control signal generation circuit.

5. A logic circuit designing method for designing an asynchronous logic circuit, wherein as constraint information on design of a signal line path for generating a control signal which controls storage operation of a state holding element, setting constraints that a minimum delay time of the signal line path is set to be a minimum time interval between a rise transition and a fall transition of said control signal which is required for normal operation of said state holding element.

6. The logic circuit designing method according to claim 5, wherein based on design specification information of a control signal generation circuit for generating said control signal, extracting a signal line path in the control signal generation circuit which makes said control signal transit.

7. The logic circuit designing method according to claim 5, wherein based on design specification information of a control signal generation circuit for generating said control signal, extracting a transition series of input/output of the control signal generation circuit for making said control signal transit and an internal signal to extract a signal line path in the control signal generation circuit corresponding to the transition series.

8. The logic circuit designing method according to claim 7, further including:
extracting said control signal from design information related to a data path circuit,
executing logic synthesis · optimization · technology mapping based on the design information related to said data path circuit,
extracting a kind of said state holding element based on said data path circuit to extract a value of said minimum time interval of the state holding element of said kind based on a cell library,
executing logic synthesis · optimization · technology mapping while executing delay addition which satisfies said constraint information on design set to the design specification information of the control signal generation circuit for generating said control signal, and
generating an asynchronous logic circuit by connecting said data path circuit and said control signal generation circuit.

9. A logic circuit designing program of a logic circuit designing device for designing an asynchronous logic circuit, which makes a design constraint setting unit execute processing of setting constraints that as constraint information on design of a signal line path for generating a control signal which controls storage operation of a state holding element, a minimum delay time of the signal line path is set to be a minimum time interval between a rise transition and a fall transition of said control signal which is required for normal operation of said state holding element.

10. The logic circuit designing program according to claim 9, which makes a signal line path extraction unit execute, based on design specification information of a control signal generation circuit for generating said control signal, processing of extracting a signal line path in the control signal generation circuit which makes said control signal transit.

11. The logic circuit designing program according to claim 9, which makes a transition series corresponding signal line path extraction unit execute, based on design specification information of a control signal generation circuit for generating said control signal, processing of extracting a transition series of input/output of the control signal generation circuit for making said control signal transit and an internal signal to extract a signal line path in the control signal generation circuit corresponding to the transition series.

12. The logic circuit designing program according to claim 11, which causes:
a control signal extraction unit to execute processing of extracting said control signal from design information related to a data path circuit,
a first logic synthesis unit to execute processing of executing logic synthesis · optimization · technology mapping based on the design information related to said data path circuit,
a minimum time interval extraction unit to execute processing of extracting a kind of said state holding element based on said data path circuit to extract a value of said minimum time interval of the state holding element of said kind based on a cell library,
a second logic synthesis unit to execute processing of executing logic synthesis · optimization · technology mapping while executing delay addition which satisfies said constraint information on design set to the design specification information of the control signal generation circuit for generating said control signal, and
a logic circuit generation unit to execute processing of generating an asynchronous logic circuit by connecting said data path circuit and said control signal generation circuit.

## Amended claims

### Amended claims under Art. 19.1 PCT

**1.** (Currently Amended) A logic circuit designing device for designing an asynchronous logic circuit, comprising:
a design constraint setting unit which sets constraints that as constraint information on design of a signal line path for generating a control signal which controls storage operation of a state holding element, a minimum delay time of the signal line path is set to be a minimum time interval between a rise transition and a fall transition of said control signal which is required for normal operation of said state holding element; and
a transition series corresponding signal line path extraction unit which extracts, based on design specification information of a control signal generation circuit for generating said control signal, a transition series of input/output of the control signal generation circuit for making said control signal transit and an internal signal to extract a signal line path in the control signal generation circuit corresponding to the transition series.

**2.** (Canceled)

**3.** (Canceled)

**4.** (Currently Amended) The logic circuit designing device according to claim 1, further comprising:
a control signal extraction unit which extracts said control signal from design information related to a data path circuit,
a first logic synthesis unit which executes logic synthesis · optimization · technology mapping based on the design information related to said data path circuit,
a minimum time interval extraction unit which extracts a kind of said state holding element based on said data path circuit to extract a value of said minimum time interval of the state holding element of said kind based on a cell library,
a second logic synthesis unit which executes logic synthesis · optimization · technology mapping while executing delay addition which satisfies said constraint information on design set to the design specification information of the control signal generation circuit for generating said control signal, and
a logic circuit generation unit which generates an asynchronous logic circuit by connecting said data path circuit and said control signal generation circuit.

**5.** (Currently Amended) A logic circuit designing method for designing an asynchronous logic circuit, comprising the steps of:
as constraint information on design of a signal line path for generating a control signal which controls storage operation of a state holding element, setting constraints that a minimum delay time of the signal line path is set to be a minimum time interval between a rise transition and a fall transition of said control signal which is required for normal operation of said state holding element; and
based on design specification information of a control signal generation circuit for generating said controls signal, extracts a transition series of input/output of the control signal generation circuit for making said control signal transit and an internal signal to extract a signal line path in the control signal generation circuit corresponding to the transition series.

**6.** (Canceled)

**7.** (Canceled)

**8.** (Currently Amended) The logic circuit designing method according to claim 5, further including:
extracting said control signal from design information related to a data path circuit,
executing logic synthesis · optimization · technology mapping based on the design information related to said data path circuit,
extracting a kind of said statue holding element based on said data path circuit to extract a value of said minimum time interval of the state holding element of said kind based on a cell library,
executing logic synthesis · optimization · technology mapping while executing delay addition which satisfies said constraint information on design set to the design specification information of the control signal generation circuit for generating said control signal, and
generating an asynchronous logic circuit by connecting said data path circuit and said control signal generation circuit.

**9.** (Currently Amended) A logic circuit designing program of a logic circuit designing device for designing an asynchronous logic circuit,
which makes a design constraint setting unit execute processing of setting constraints that as constraint information on design of a signal line path for generating a control signal which controls storage operation of a state holding element, a minimum delay time of the signal line path is set to be a minimum time interval between a rise transition and a fall transition of said control signal which is required for normal operation of said state holding element, and
which makes a transition series corresponding signal line path extraction unit execute, based on design specification information of a control signal generation circuit for generating said control signal, processing of extracting a transition series of input/output of the control signal generation circuit for making said control signal transit and an internal signal to extract a signal line path in the control signal generation circuit corresponding to the transition series.

**10.** (Canceled)

**11.** (Canceled)

**12.** (Currently Amended) The logic circuit designing program according to claim 9, which causes:
a control signal extraction unit to execute processing of extracting said control signal from design information related to a data path circuit,
a first logic synthesis unit to execute processing of executing logic synthesis · optimization · technology mapping based on the design information related to said data path circuit,
a minimum time interval extraction unit to execute processing of extracting a kind of said state holding element based on said data path circuit to extract a value of said minimum time interval of the state holding element of said kind based on a cell library,
a second logic synthesis unit to execute processing of executing logic synthesis · optimization · technology mapping while executing delay addition which satisfies said constraint information on design set to the design specification information of the control signal generation circuit for generating said control signal, and
a logic circuit generation unit to execute processing of generating an asynchronous logic circuit by connecting said data path circuit and said control signal generation circuit.
